# EUROPÄISCHE PATENTANMELDUNG

(11) **EP 1 843 264 A1**
(43) Veröffentlichungstag der Anmeldung: **10.10.2007**
(21) Anmeldenummer: 06007433.3
(22) Anmeldetag: 07.04.2006
(51) Int. Cl.: G06F 17/50

(54) **Graphische Umgebung zum Erstellen einer graphischen Darstellung und Verfahren zum Erzeugen einer graphischen Darstellung**

(71) Anmelder: SIEMENS AKTIENGESELLSCHAFT, 80333 München (DE)
(72) Erfinder: Brüll, Martin, 93092 Barbing (DE); Burger, Thomas, Dr., 93051 Regensburg (DE); Kunze, Marco, Dr., 93051 Regensburg (DE)

(57) **Zusammenfassung**

Die Erfindung betrifft eine graphische Umgebung zum Erstellen einer graphische Darstellung (20,40,50) mittels Funktionsblöcken (21-29,51-65,67), mehrerer Blocktypen und die Funktionsblöcke (21-29,51-65,67) verbindenden Siqnalflusspfeilen (30,66). Die graphische Umgebung ordnet der graphischen Darstellung (20,40,50) aufgrund der logischen Verknüpfung der einzelnen Funktionsblöcke (21-29,51-65,67) durch die Signalflusspfeile (30,66) ein Netzwerk zu und sortiert die Anordnung der Funktionsblöcke (21-29,51-65,67) in diesem Netzwerk automatisch um, sodass eine umsortierte graphische Darstellung (31,68) entsteht.

## Beschreibung

Graphische Umgebung zum Erstellen einer graphischen Darstellung und Verfahren zum Erzeugen einer graphischen Darstellung

Die Erfindung betrifft eine graphische Umgebung zum Erstellen einer graphischen Darstellung und Verfahren zum Erzeugen einer graphischen Darstellung.

Bei der Entwicklung von elektronischen Schaltungen, Steuerungen oder Regelungen, wie z.B. die Funktionen für eine Motorsteuerung, werden häufig graphische Simulationsumgebungen verwendet. Die graphische Simulationsumgebung ist ein graphischer Editor, mit dem mittels Funktionsblöcken verschiedener Blocktypen z.B. Signalflusspläne oder Schaltpläne für elektronische Schaltungen als graphische Darstellung editiert werden, die anschließend mit einem Simulationsprogramm simuliert werden können. Die graphische Darstellung kann unter Anderem auch für die Dokumentation verwendet werden.

Die graphische Darstellung wird zunächst für die Entwicklung beispielsweise der elektronischen Schaltungen, Steuerungen oder Regelungen erstellt, weshalb der Anwender in der Regel nicht auf eine besonders übersichtliche Darstellung achtet. Dies ist insbesondere dann der Fall, wenn der Entwickler mittels der Simulationsumgebung die elektronische Schaltung, Steuerung oder Regelung während des Entwurfs ändert. Dadurch ist es möglich, dass beispielsweise ein Funktionsblock einen anderen Funktionsblock teilweise überlappt oder Signalflusspfeile Funktionsblöcke oder andere Signalflusspfeile schneiden. Dies kann zu einer unübersichtlichen graphischen Darstellung führen, die für eine Dokumentation oder einer späteren Weiterentwicklung durch einen weiteren Anwender ungeeignet ist.

Die Aufgabe der vorliegenden Erfindung ist es daher, eine graphische Umgebung zum Erstellen einer graphische Darstellung und ein Verfahren zum Erzeugen einer graphischen Darstellung mit einer graphischen Umgebung derart auszuführen, dass die Lesbarkeit der graphischen Darstellung verbessert wird.

Die Aufgabe der Erfindung wird gelöst durch eine graphische Umgebung zum Erstellen einer graphischen Darstellung mittels Funktionsblöcken, mehrerer Blocktypen und die Funktionsblöcke verbindenden Signalflusspfeilen. Hierbei ordnet die graphische Umgebung der graphischen Darstellung aufgrund der logischen Verknüpfungen der einzelnen Funktionsblöcke durch die Signalflusspfeile ein Netzwerk zu.

Bevorzugt wird die Anordnung der Funktionsblöcke in diesem Netzwerk automatisch umsortiert, sodass eine umsortierte graphische Darstellung entsteht. Der Begriff "graphische Umgebung" soll weit verstanden werden. So wird unter dem Begriff "graphische Umgebung" auch eine Umgebung verstanden, aufgrund derer die graphische Darstellung mit einer Programmiersprache oder einer Makrosprache erzeugt wird.

Die graphische Darstellung besteht aus den mit Signalflusspfeilen verbundenen Funktionsblöcken der einzelnen Blocktypen. Die graphische Darstellung repräsentiert demnach ein Netzwerk, wobei Knoten die einzelnen Funktionsblöcke und Zweige die Signalflusspfeile des Netzwerkes darstellen. Die erfindungsgemäße graphische Umgebung, die insbesondere als eine graphische Simulationsumgebung eines mathematischen Simulationsprogramms für die graphische Darstellung einer zu simulierenden Funktion ausgebildet ist, ist derart ausgeführt, dass sie zunächst zur fertig gesellten graphischen Darstellung das ihr zugeordnete Netzwerk bestimmt. Anschließend werden die einzelnen Funktionsblöcke derart umsortiert, sodass die durch die Signalflusspfeile vorgegebenen logischen Beziehungen innerhalb der graphischen Darstellung bzw. des der graphischen Darstellung zugeordneten Netzwerks unverändert bleiben. Die Umsortierung erfolgt beispielsweise aufgrund einer vorher festgelegten hierarchischen Beziehung der Blocktypen zueinander und/oder einer vorher festgelegten Vorzugssignalflussrichtung innerhalb des Netzwerks.

Aufgrund der vorab festgelegten Vorzugssignalflussrichtung wird die graphische Darstellung z.B. derart umsortiert, dass die Signalflusspfeile der umsortierten graphischen Darstellung vorzugsweise horizontal und/oder vertikal bezüglich der graphischen Darstellung verlaufen. Dadurch kann die Anzahl von Überschneidungen von Signalflusspfeilen der umsortierten graphischen Darstellung zumindest verringert werden. Aufgrund der Vorzugssignalflussrichtung kann es auch vorgesehen sein, dass der Signalfluss der umsortierten graphischen Darstellung z.B. speziell von links nach rechts oder von unten nach oben verläuft.

Nach einer Ausführungsform der erfindungsgemäßen graphischen Umgebung ordnet diese aufgrund der hierarchischen Beziehung der Blocktypen zueinander zunächst alle Funktionsblöcke des Blocktyps mit der höchsten Hierarchiestufe der graphischen Darstellung an einer vorher festgelegten Seite und/oder Stelle der umsortierten graphischen Darstellung an. Aufgrund der hierarchischen Beziehung ist es z.B. möglich, dass Funktionsblöcke eines bestimmten Blocktyps, beispielsweise ein Textblock, stets an einer bestimmten Stelle in der umsortierten graphischen Darstellung angeordnet werden. Wird dieser Textblock z.B. in mehreren Simulationsebenen verwendet, dann erscheint dieser stets an derselben Stelle innerhalb der umsortierten graphischen Darstellung, wodurch sich die Lesbarkeit der umsortierten im Vergleich zur ursprünglichen graphischen Darstellung erhöht. Aufgrund der hierarchischen Beziehung kann es aber auch vorgesehen sein, Funktionsblöcke eines bestimmten Blocktyps an vorher festgelegten Stellen oder Seiten innerhalb der umsortierten graphischen Darstellung anzuordnen. Handelt es sich bei diesen Funktionsblöcken z.B. um Eingänge einer zu simulierenden Funktion, so können diese beispielsweise untereinander angeordnet werden.

Gemäß einer Variante der erfindungsgemäßen graphischen Umgebung ordnet diese unter Berücksichtigung der logischen Verknüpfung der Funktionsblöcke der graphischen Darstellung durch die Signalflusspfeile neben den Funktionsblöcken eines bestimmten Blocktyps einen Funktionsblock eines Blocktyps mit der nächst niedrigeren Hierarchiestufe innerhalb der umsortierten graphischen Darstellung an.

Hat das der graphischen Darstellung zugeordnete Netzwerk mehrere Unternetzwerke, die jeweils nicht durch einen Signalflusspfeil miteinander verbunden sind, so ist es nach einer Variante der erfindungsgemäßen graphischen Umgebung vorgesehen, die den einzelnen Unternetzwerken zugeordneten Funktionsblöcke unabhängig voneinander für die umsortierte graphische Darstellung umzusortieren. Diese Variante der erfindungsgemäßen Umgebung hat den Vorteil, dass Überschneidungen von Signalflusspfeilen unterschiedlicher Unternetzwerke vermieden werden können.

Die Aufgabe der Erfindung wird auch gelöst durch ein Verfahren zum Erzeugen einer graphischen Darstellung, aufweisend folgende Verfahrensschritte:
- Erzeugen einer ersten graphischen Darstellung, die mehrere Funktionsblöcke mehrerer Blocktypen und die Funktionsblöcke verbindende Signalflusspfeile aufweist, und
- Zuordnen eines Netzwerks zu der ersten graphischen Darstellung, wobei das Zuordnen aufgrund der logischen Verknüpfung der einzelnen Funktionsblöcke durch die Signalflusspfeile erfolgt.

Nachdem das Netzwerk zugeordnet ist, wird bevorzugt eine zweiten graphische Darstellung aus der ersten graphischen Darstellung durch Umsortieren der Funktionsblöcke innerhalb des Netzwerks erzeugt.

Durch das erfindungsgemäße Verfahren bzw. die erfindungsgemäße graphische Umgebung wird ein "Model-Routing" für die Zuordnung eines Netzwerkes aufgrund der logischen Verknüpfungen der einzelnen Funktionsblöcke durch die Signalflusspfeile vorgeschlagen. Die Beziehungen der einzelnen Funktionsblöcke durch die Signalflusspfeile zueinander lassen sich als das Netzwerk darstellen. Basierend auf der vorher separat definierten Hierarchie der Blocktypen sowie der logischen Verknüpfung der Funktionsblöcke zueinander ergibt sich ein Sortieralgorithmus der einzelnen Funktionsblöcke. Basierend auf dem Ergebnis der Sortierung werden die Funktionsblöcke der graphischen Darstellung auch innerhalb mehrerer Simulations- oder Modellebenen neu angeordnet.

Durch die erfindungsgemäße graphische Umgebung bzw. durch das erfindungsgemäße Verfahren wird die Lesbarkeit der entstehenden graphischen Darstellung verbessert. Die erfindungsgemäße graphische Umgebung bzw. das erfindungsgemäße Verfahren unterstützt den Anwender beim Erstellen einer graphischen Darstellung, die z.B. nicht nur für die Simulation, sondern auch für eine Dokumentation vorgesehen ist. Der Anwender wird dahingehend entlastet, dass er während der Erstellung der graphischen Darstellung, die zunächst zum Zwecke der Simulation angefertigt wird, nicht durch Überlegungen hinsichtlich einer übersichtlichen Darstellung für die Dokumentation abgelenkt wird. Ein nachträgliches manuelles Bearbeiten für eine ansprechende Dokumentation ist aufgrund der erfindungsgemäßen Umgebung bzw. aufgrund des erfindungsgemäßen Verfahrens nicht mehr notwendig. Je nach Anforderung kann das Ergebnis der Umorientierung von verschiedenen Rahmenbedingungen zusätzlich beeinflusst werden, wie z. B. Größenbegrenzung von Simulationsebenen auf beispielsweise DIN A4 oder durch eine Begrenzung der Anzahl bestimmter Funktionsblöcke pro Simulationsebene. Ferner kann diese Funktionalität unter Zuhilfenahme veränderter Rahmenbedingungen automatisch ein Umsortieren durchführen, was bei einer manuellen Durchführung einen relativ hohen Mehraufwand bedeuten würde. Das ermittelte Netzwerk kann zahlreichen weiteren Anwendungen zugrunde liegen, wie z. B. einem Debug-Modus basierend auf dem gegenwärtigen Datenfluss, der sich in diesem Netzwerk widerspiegelt.

Ausführungsbeispiele einer erfindungsgemäßen graphischen Simulationsumgebung sind beispielhaft in den schematischen Zeichnungen dargestellt. Es zeigen:
- Fig. 1: einen Rechner,
- Fig. 2: eine graphische Darstellung,
- Fig. 3: eine aus der graphischen Darstellung der Fig. 2 durch Umsortieren entstandene graphische Darstellung,
- Fig. 4: eine weitere graphische Darstellung,
- Fig. 5: eine weitere graphische Darstellung und
- Fig. 6: eine aus der graphischen Darstellung der Fig. 5 durch Umsortieren entstandene graphische Darstellung.

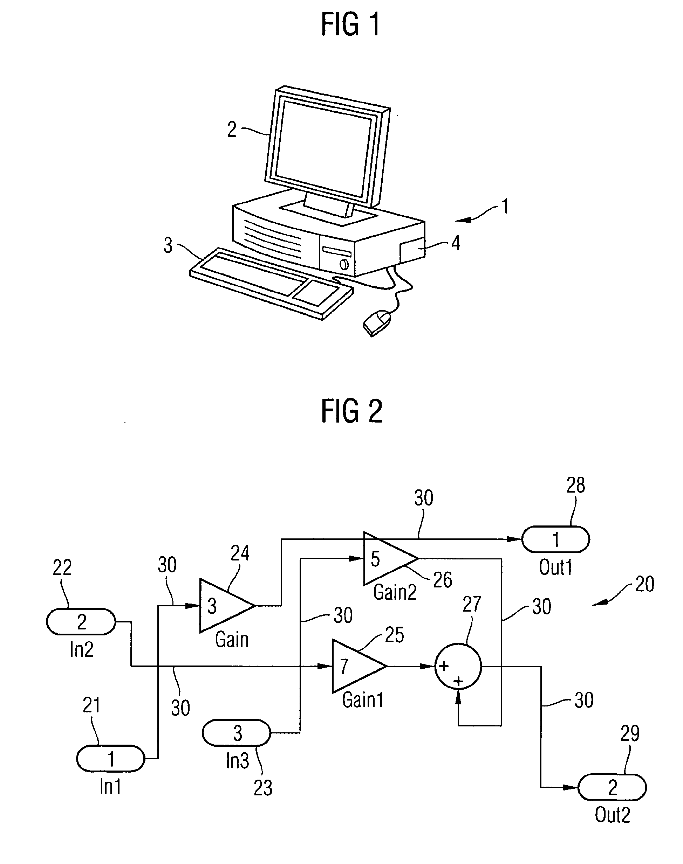

Die Figur 1 zeigt einen Rechner 1, auf dem im Falle des vorliegenden Ausführungsbeispiels ein Simulationsprogramm zum Simulieren von u.A. elektronischen Schaltungen oder Regelungen und Steuerungen installiert ist. Auf dem Rechner 1 ist ferner eine erfindungsgemäße Simulationsumgebung in Form eines Rechnerprogramms installiert. Die graphische Simulationsumgebung ist ein graphischer Editor, mit dem eine graphische Darstellung für die zu simulierende Schaltung, Regelung oder Steuerung mittels Funktionsblöcken verschiedener Blocktypen erstellt, auf dem Bildschirm 2 des Rechners 1 angezeigt und mit einem nicht dargestellten Drucker ausgedruckt werden kann. Aufgrund der graphischen Darstellung kann das Simulationsprogramm die der graphischen Darstellung zugeordnete Schaltung simulieren.

Die Figur 2 zeigt eine graphische Darstellung 20, die so auch mit einer gewöhnlichen Simulationsumgebung hergestellt werden könnte. Bei der graphischen Darstellung 20 handelt es sich im Falle des vorliegenden Ausführungsbeispiels um einen Signalflussplan für eine zu simulierende Motorsteuerung. Die graphische Darstellung 20 umfasst mehrere Funktionsblöcke 21-29 verschiedener Blocktypen, die mit Signalflusspfeilen 30 verbunden sind. Bei den dargestellten Blocktypen handelt es sich um einen Blocktyp "Eingang", einen Blocktyp "Ausgang", einen Blocktyp "Verstärker" und einen Blocktyp "Addierer".

Im Falle des vorliegenden Ausführungsbeispiels umfasst die graphische Darstellung 20 einen ersten Funktionsblock 21, einen zweiten Funktionsblock 22 und einen dritten Funktionsblock 23 vom Blocktyp "Eingang", einen vierten Funktionsblock 24, einen fünften Funktionsblock 25 und einen sechsten Funktionsblock 26 vom Blocktyp "Verstärker", einen siebten Funktionsblock 27 vom Blocktyp "Addierer" und einen achten Funktionsblock 28 und einen neunten Funktionsblock 29 vom Blocktyp "Ausgang". Wie es aus der Figur 2 ersichtlich ist, ist die graphische Darstellung 20 relativ unübersichtlich, da sich beispielsweise Signalflusspfeile 30 schneiden und auch einer der Signalflusspfeile 30 den sechsten Funktionsblock 26 überlappt. Um die Lesbarkeit der graphischen Darstellung 20 zu erhöhen, ist es zwar möglich, die einzelnen Funktionsblöcke 21-29 manuell umzuordnen. Dies ist jedoch nicht nur aufwändig, sondern es ist auch unwahrscheinlich, ein einheitliches Erscheinungsbild für verschiedene graphische Darstellungen, z.B. zweier Simulationsebenen, zu erhalten.

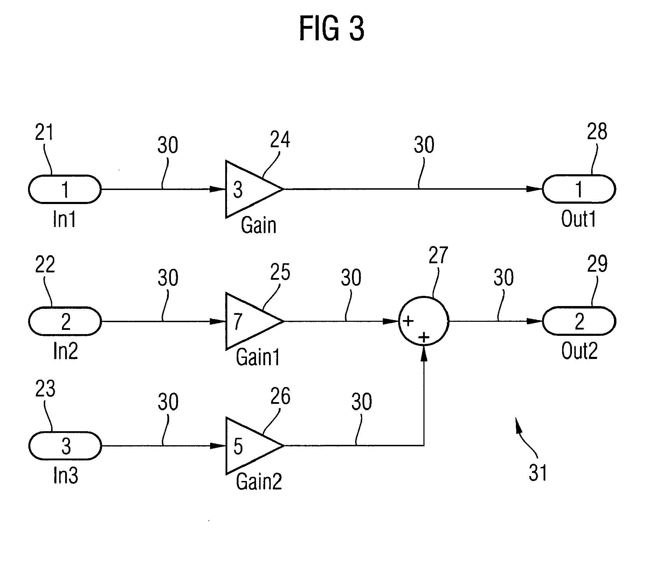

Im Falle des vorliegenden Ausführungsbeispiels läuft auf dem Rechner 1 das der erfindungsgemäßen Simulationsumgebung zugeordnete Rechnerprogramm. Dieses Rechnerprogramm analysiert zunächst die graphische Darstellung 20 und ordnet der graphischen Darstellung 20 ein Netzwerk zu. Die Signalflusspfeile 30 entsprechen den Zweige dieses Netzwerkes und die einzelnen Funktionsblöcke 21-29 entsprechen den Knoten des Netzwerks. Dieses Netzwerk ist die Basis für eine Umsortierung der einzelnen Funktionsblöcke 21-29, sodass die in der Fig. 3 dargestellte umsortierte graphische Darstellung 31 entsteht. Die umsortierte graphische Darstellung 31 und die in der Fig. 2 dargestellte ursprüngliche graphische Darstellung 20 beschreiben dieselbe Motorsteuerung und unterscheiden sich lediglich durch ihre unterschiedliche Anordnung der einzelnen Funktionsblöcke 21-29.

Ferner ist im Falle des vorliegenden Ausführungsbeispiels das Rechnerprogramm derart ausgeführt, dass es das ermittelte Netzwerk in mehrere Unternetzwerke unterteilt, wenn dies möglich ist. Unternetzwerke sind Netzwerkteile, die vom restlichen Netzwerk getrennt sind, also vom restlichen Netzwerk durch keinen Signalflusspfeil miteinander verbunden sind.

Nachdem das auf dem Rechner 1 laufende Rechnerprogramm das der graphischen Darstellung 20 zugeordnete Netzwerk ermittelt hat, ruft es eine in einer Datenbank 4 des Rechners 1 hinterlegte und vorab abgespeicherte Hierarchie von Blocktypen und eine Vorzugssignalflussrichtung der Signalflusspfeile 30 ab.

Im Falle des vorliegenden Ausführungsbeispiels verläuft die Vorzugssignalflussrichtung von links nach rechts. Des Weiteren ist die vorab festgelegte Hierarchie der Blocktypen die Folgende:

Blocktyp "Eingang", Blocktyp "Verstärker", Blocktyp "Addierer" und Blocktyp "Ausgang", wobei der Blocktyp "Eingang" die höchste Hierarchiestufe hat.

Aufgrund der Analyse erkennt das Rechnerprogramm, dass das der graphischen Darstellung 20 zugeordnete Netzwerke mehrere Unternetzwerke umfasst, und zwar ein ersten Unternetzwerk, dem die Funktionsblöcke 21, 24, 28 zugeordnet sind, und ein zweites Unternetzwerk, dem die restlichen Funktionsblöcke zugeordnet sind.

Anschließend ermittelt das Rechnerprogramm den oder die Funktionsblöcke der obersten Hierarchiestufe. Das sind im Falle des vorliegenden Ausführungsbeispiels die ersten drei Funktionsblöcke 21, 22, 23 des Blocktyps "Eingang". Aufgrund der vorgegebenen Vorzugssignalflussrichtung und aufgrund einer in der Datenbank 4 abgespeicherten Information ordnet im Falle des vorliegenden Ausführungsbeispiels das Rechnerprogramm für die Umsortierung die Funktionsblöcke 21-23 des Blocktyps "Eingang" am linken Rand der umsortierten graphischen Darstellung 31 von oben nach unten an. Die Anordnung der Funktionsblöcke 21-23 kann hier beispielsweise nach einer vorgegebenen Reihenfolge, nach der Beschriftung der Funktionsblöcke 21-23 oder auch zufällig erfolgen.

Anschließend sucht das Rechnerprogramm diejenigen Funktionsblöcke des Blocktyps mit der nächst niedrigeren Hierarchiestufe, die mit einem Signalflusspfeil 30 mit einem der Funktionsblöcke 24-26 des Blocktyps "Eingang" verbunden sind. Dies sind im Falle des vorliegenden Ausführungsbeispiels die Funktionsblöcke 24-25 des Blocktyps "Verstärker". Diese werden für die umsortierte graphische Darstellung 31 aufgrund der vorgegebene Vorzugssignalflussrichtung rechts von den Funktionsblöcken 21-23 des Blocktyps "Eingang" unter Berücksichtigung des entsprechenden Signalflusspfeils 30, der einen Funktionsblock 21-23 vom Blocktyp "Eingang" mit einem Funktionsblock 24-26 vom Blocktyp "Verstärker" verbindet. Außerdem verbindet das Rechnerprogramm die bis jetzt umsortierten Funktionsblöcke 21-26 mit entsprechenden Signalflusspfeilen 30.

Anschließend sucht das Rechnerprogramm diejenigen Funktionsblöcke des Blocktyps mit der nächst niedrigeren Hierarchiestufe, die mit einem Signalflusspfeil 30 mit einem der Funktionsblöcke des Blocktyps "Verstärker" oder "Eingang" verbunden sind. Dies ist im Falle des vorliegenden Ausführungsbeispiels der siebte Funktionsblock 27 des Blocktyps "Addierer". Der siebte Funktionsblock 27 ist dabei mit dem fünften und sechsten Funktionsblock 25, 26 vom Blocktyp "Verstärker" verbunden. Somit ordnet das Rechnerprogramm für die umsortierte graphische Darstellung 31 den siebten Funktionsblock 27 neben den fünften Funktionsblock 25 an und verbindet den siebten Funktionsblock 27 mit jeweils einem Signalflusspfeil 30 mit dem fünften bzw. dem sechsten Funktionsblock 26.

Danach sucht das Rechnerprogramm diejenigen Funktionsblöcke des Blocktyps mit der nächst niedrigeren Hierarchiestufe, die mit einem Signalflusspfeil 30 mit einem der Funktionsblöcke des Blocktyps "Addierer", "Verstärker" oder "Eingang" verbunden sind. Dies sind im Falle des vorliegenden Ausführungsbeispiels die Funktionsblöcke 28, 29 des Blocktyps "Ausgang". Der achte Funktionsblock 28 ist dabei mit dem vierten Funktionsblock 24 vom Blocktyp "Verstärker" und der neunte Funktionsblock 29 ist mit dem siebten Funktionsblock 27 vom Blocktyp "Addierer" durch einen Signalflusspfeil 30 verbunden. Somit ordnet das Rechnerprogramm für die umsortierte graphische Darstellung 31 den achten Funktionsblock 28 neben den vierten Funktionsblock 24 und den neunten Funktionsblock 29 neben den siebten Funktionsblock 27 an und verbindet diese mit entsprechenden Signalflusspfeilen 30.

Im Falle des vorliegenden Ausführungsbeispiels ist das Rechnerprogramm auch derart ausgeführt, dass es Funktionsblöcke derselben Hierarchiestufe entlang einer vertikalen Linie ausrichtet.

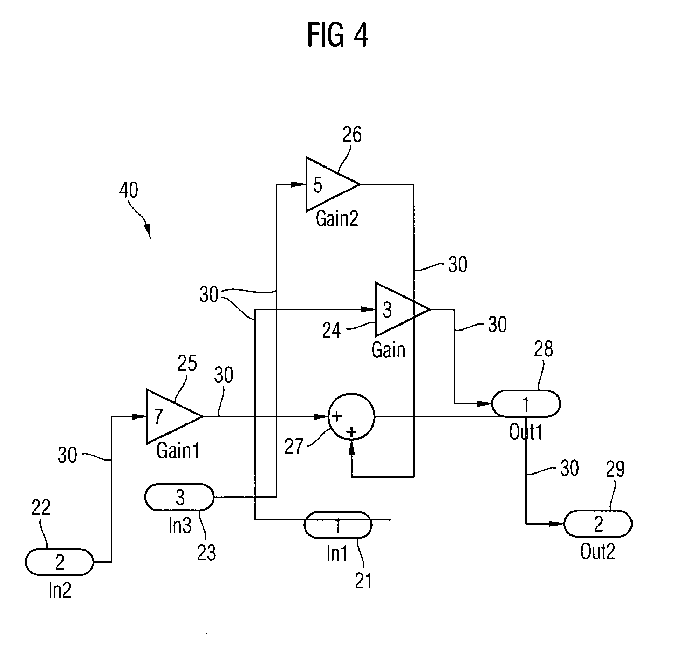

Die Figur 4 zeigt eine weitere graphische Darstellung 40, die derselben Motorsteuerung wie die graphische Darstellungen 20, 31 zugeordnet ist. Wird diese graphische Darstellung 40 mit dem auf dem Rechner 1 laufenden Rechnerprogramm automatisch überarbeitet, so sortiert dieses die Funktionsblöcke 21-29 derart um, dass die in der Figur 3 dargestellte umsortierte graphische Darstellung 31 entsteht.

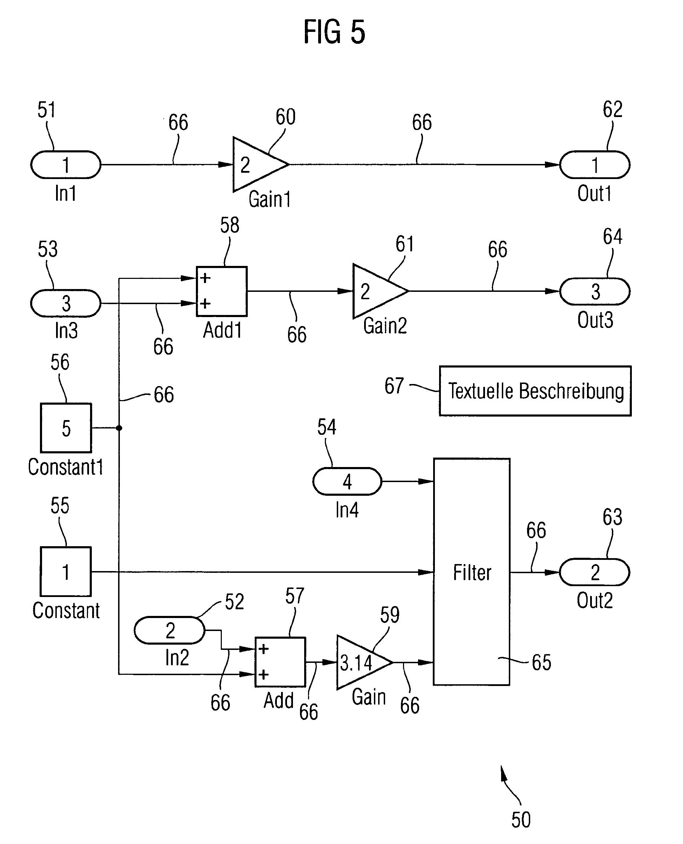

Die Figur 5 zeigt eine weitere graphische Darstellung 50, die so auch mit einer gewöhnlichen Simulationsumgebung hergestellt werden könnte. Bei der graphischen Darstellung 50 handelt es sich im Falle des vorliegenden Ausführungsbeispiels um einen Signalflussplan für eine weitere zu simulierende Motorsteuerung. Im Falle des vorliegenden Ausführungsbeispiels weist die graphische Darstellung 50 mehrere Funktionsblöcke 51-65 verschiedener Blocktypen, die mit Signalflusspfeilen 66 verbunden sind, und einen Textblock 67 auf. Bei den dargestellten Blocktypen handelt es sich um einen Blocktyp "Eingang", einen Blocktyp "Ausgang", einen Blocktyp "Verstärker", einen Blocktyp "Filter", einen Blocktyp "Konstanter Wert" und einen Blocktyp "Addierer".

Im Falle des vorliegenden Ausführungsbeispiels umfasst die graphische Darstellung 50 einen ersten Funktionsblock 51, einen zweiten Funktionsblock 52, einen dritten Funktionsblock 53 und einen vierten Funktionsblock 54 vom Blocktyp "Eingang", einen fünften Funktionsblock 55 und einen sechsten Funktionsblock 56 vom Blocktyp "Konstanter Wert", einen siebten Funktionsblock 57 und einen achten Funktionsblock 58 vom Blocktyp "Verstärker", einen neunten Funktionsblock 59, einen zehnten Funktionsblock 60 und einen elften Funktionsblock 61 vom Blocktyp "Addierer", einen zwölften Funktionsblock 62, einen 13. Funktionsblock 63 und einen 14. Funktionsblock 64 vom Blocktyp "Ausgang" und einen 15. Funktionsblock 65 vom Blocktyp "Filter". Wie es aus der Figur 5 ersichtlich ist, ist die graphische Darstellung 50 relativ unübersichtlich, da sich beispielsweise Signalflusspfeile 66 schneiden. Um die Lesbarkeit der graphischen Darstellung 50 zu erhöhen, ist es zwar möglich, die einzelnen Funktionsblöcke 61-65 manuell umzuordnen. Dies ist jedoch nicht nur aufwändig, sondern es ist auch unwahrscheinlich, ein einheitliches Erscheinungsbild für verschiedene graphische Darstellungen, z.B. zweier Simulationsebenen, zu erhalten.

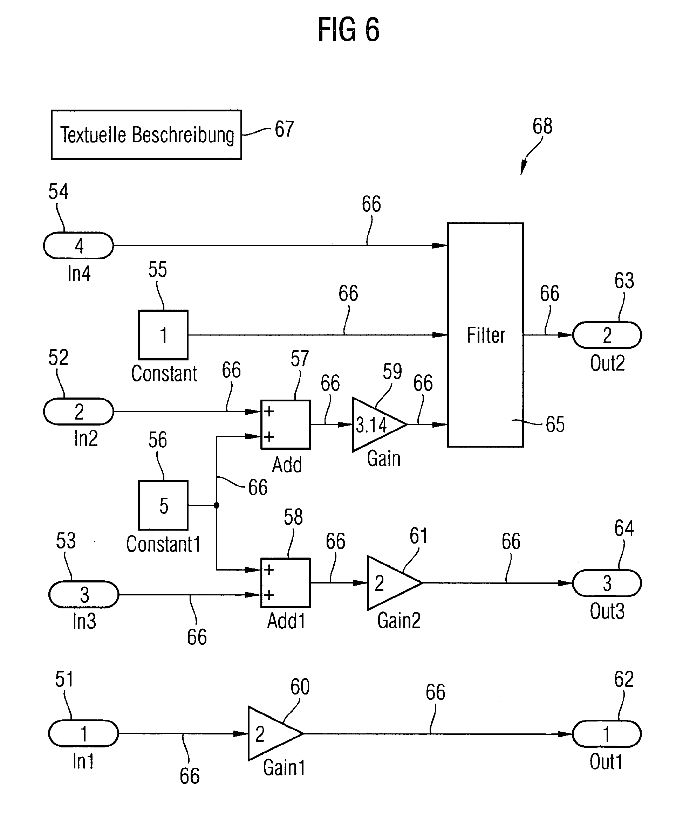

Im Falle des vorliegenden Ausführungsbeispiels läuft auf dem Rechner 1 das der erfindungsgemäßen Simulationsumgebung zugeordnete Rechnerprogramm, das im Falle des vorliegenden Ausführungsbeispiels zunächst die graphische Darstellung 50 analysiert und ihr ein Netzwerk zuordnet. Die Signalflusspfeile 66 entsprechen den Zweige dieses Netzwerkes und die einzelnen Funktionsblöcke 51-67 entsprechen den Knoten des Netzwerks. Dieses Netzwerk ist die Basis für eine Umsortierung der einzelnen Funktionsblöcke 51-67, sodass die in der Fig. 6 dargestellte umsortierte graphische Darstellung 68 entsteht. Die umsortierte graphische Darstellung 68 und die in der Fig. 5 dargestellte ursprüngliche graphische Darstellung 50 beschreiben dieselbe Motorsteuerung und unterscheiden sich lediglich durch die unterschiedliche Anordnung der einzelnen Funktionsblöcke 51-67, d.h. die logische Verknüpfungen der einzelnen Funktionsblöcke 51-67 der beiden graphischen Darstellungen 50, 68 sind dieselben.

Ferner ist im Falle des vorliegenden Ausführungsbeispiels das Rechnerprogramm derart ausgeführt, dass es das ermittelte Netzwerk in mehrere Unternetzwerke unterteilt, wenn dies möglich ist. Unternetzwerke sind Netzwerkteile, die vom restlichen Netzwerk getrennt sind, also vom restlichen Netzwerk durch keinen Signalflusspfeil miteinander verbunden sind. Im Falle des vorliegenden Ausführungsbeispiels erkennt das Rechnerprogramm drei Unternetzwerke. Dem ersten Unternetzwerk ist lediglich der Textblock 67, dem zweiten Unternetzwerk sind der erste, zehnte und zwölfte Funktionsblock 51, 60, 62 mit den dazugehörigen Signalflusspfeilen 66 und dem dritten Unternetzwerk sind die restlichen Funktionsblöcke mit den dazugehörigen Signalflusspfeilen 66 zugeordnet.

Anschließend ermittelt im Falle des vorliegenden Ausführungsbeispiels das Rechnerprogramm eine hierarchische Anordnung der einzelnen Blocktypen in der Richtung von oben nach unten und von links nach rechts bezüglich der Darstellungsebene der umzusortierenden graphischen Darstellung 50. Im Falle des vorliegenden Ausführungsbeispiels ist die Information über die Hierarchien in der Datenbank 4 des Rechners 1 hinterlegt und wurde vorab festgelegt. Die Hierarchie "oben nach unten" ist hier wie folgt
- Klasse 1:: Funktionsblöcke vom Blocktyp "Textblock" (Textblock),
- Klasse 2:: Funktionsblöcke vom Blocktyp "Filter" und
- Klasse 3:: Funktionsblöcke der übrigen Blocktypen
und die Hierarchie "links nach rechts" ist hier wie folgt festgelegt:
- Klasse 3:: xFunktionsblöcke vom Blocktyp "Eingang",
- Klasse 2:: Funktionsblöcke vom Blocktyp "Konstanter Wert",
- Klasse 3:: Funktionsblöcke der übrigen Blocktypen außer vom Blocktyp "Ausgang" und
- Klasse 4:: Funktionsblöcke vom Blocktype "Ausgang".

Aufgrund dieser Kriterien erscheint daher im Falle des vorliegenden Ausführungsbeispiels der Textblock 67 links oben in der in der Fig. 6 dargestellten umsortierten graphischen Darstellung 68. Der 15. Funktionsblock 65 vom Blocktyp "Filter" wird wegen der hierarchischen Anordnung "oben nach unten" in der umsortierten graphischen Darstellung 68 unterhalb des Textblocks 67 angeordnet. Dadurch ist auch festgelegt, dass die dem zweiten Unternetzwerk zugeordneten Funktionsblöcke 51, 60, 62 unterhalb den dem dritten Unternetzwerk zugeordneten Funktionsblöcken in der umsortierten graphischen Darstellung 68 erscheinen, da der 15. Funktionsblock 65 vom Blocktyp "Filter" im Falle des vorliegenden Ausführungsbeispiels dem dritten Unternetzwerk zugeordnet ist. Somit werden zunächst die den drei Unternetzwerken zugeordneten Funktionsblöcke gemäß der hierarchischen Anordnung "oben nach unten" umsortiert.

Anschließend werden die den drei Unternetzwerken zugeordneten Funktionsblöcken entsprechend den festgelegten Hierarchien, insbesondere der Hierarchie "links nach rechts" umsortiert.

Dem ersten Netzwerk ist nur der Textblock 67 zugeordnet, der links oben bezüglich der Darstellungsebene der umsortierten graphischen Darstellung 68 angeordnet wird.

Anschließend sortiert das Rechnerprogramm die dem dritten Netzwerk zugeordneten Funktionsblöcke insbesondere aufgrund der Hierarchie "link nach rechts" um. Somit werden zunächst die Funktionsblöcke 52-54 des Blocktyps "Eingang" an der linken Seite und die Funktionsblöcke 63, 64 des Blocktyps "Ausgang" an der rechten Seite der Darstellungsebene der umsortierten graphischen Darstellung 67 angeordnet. Die Funktionsblöcke 55, 56 des Blocktyps "Konstanter Wert" werden leicht nach rechts verschoben bezüglich den Funktionsblöcken 52-54 des Blocktyps "Eingang" angeordnet. So können diese aufgrund ihrer Anordnung von den Funktionsblöcken 52-54 unterschieden werden.

Aufgrund der Hierarchie "links nach rechts" werden die Funktionsblöcke 57, 58 vom Blocktyp "Addierer", die Funktionsblöcke 59, 61 vom Blocktyp "Verstärker" und der Funktionsblock 65 vom Blocktyp "Filter" rechts verschoben bezüglich den Funktionsblöcken 55, 56 des Blocktyps "Konstanter Wert" angeordnet. Aufgrund der durch die Signalflusspfeile 66 bedingten logischen Verknüpfung werden außerdem die Funktionsblöcke 57, 58 vom Blocktyp "Addierer", die Funktionsblöcke 59, 61 vom Blocktyp "Verstärker" und der Funktionsblock 65 vom Blocktyp "Filter" wie in der Fig. 6 gezeigt für die umsortierte graphische Darstellung 68 umsortiert.

Schließlich werden noch die Funktionsblöcke 51, 60, 62, die dem zweiten Unternetzwerk zugeordnet sind, aufgrund der festgelegten Hierarchien wie in der Fig. 6 dargestellt umsortiert, wodurch die umsortierte graphische Darstellung 68 entsteht.

Im Falle des vorliegenden Ausführungsbeispiels ergibt sich durch die festgelegten Hierarchien ein einheitliches Erscheinungsbild derart, dass der rein informative Textblock 67, der für die Simulation der Motorsteuerung als solche nicht nötig ist, bei der umsortierten graphischen Darstellung 68, die insbesondere für die Dokumentation vorgesehen ist, in der Regel stets links oben erscheint. Ferner werden Funktionsblöcke eines bestimmten Blocktyps, hier vom Blocktyp "Filter", automatisch an bestimmten exponierten Stellen innerhalb der umsortierten graphischen Darstellung einheitlich gesetzt, was die Lesbarkeit der umsortierten graphischen Darstellung erhöhen kann.

## Patentansprüche

1. Graphische Umgebung zum Erstellen einer graphischen Darstellung mittels Funktionsblöcken (21-29, 51-65, 67), mehreren Blocktypen und die Funktionsblöcke (21-29, 51-65, 67) verbindenden Signalflusspfeilen (30, 66), wobei die graphische Umgebung der graphischen Darstellung aufgrund der logischen Verknüpfung der einzelnen Funktionsblöcke (21-29, 51-65, 67) durch die Signalflusspfeile (30, 66) ein Netzwerk zuordnet.

2. Graphische Darstellung nach Anspruch 1, die die Anordnung der Funktionsblöcke (21-29, 51-65, 67) in diesem Netzwerk automatisch umsortiert, sodass eine umsortierte graphische Darstellung (31, 68) entsteht.

3. Graphische Umgebung nach Anspruch 2, die aufgrund einer vorher festgelegten hierarchischen Beziehung der Blocktypen zueinander und/oder einer vorher festgelegten Vorzugssignalflussrichtung innerhalb des Netzwerks die Anordnung der Funktionsblöcke (21-29, 51-65, 67) in diesem Netzwerk automatisch umsortiert, sodass die umsortierte graphische Darstellung (31, 68) entsteht.

4. Graphische Umgebung nach Anspruch 3, bei der die Vorzugssignalflussrichtung horizontal und/oder vertikal bezüglich der graphischen Darstellung (31, 68) verläuft.

5. Graphische Umgebung nach Anspruch 3 oder 4, die aufgrund der hierarchischen Beziehung der Blocktypen zueinander zunächst alle Funktionsblöcke (21-29, 51-65, 67) des Blocktyps mit der höchsten Hierarchiestufe der graphischen Darstellung an einer vorher festgelegten Position innerhalb der umsortierten graphischen Darstellung (31, 68) oder einer vorher festgelegten Seite der umsortierten graphischen Darstellung (31, 68) anordnet.

6. Graphische Umgebung nach einem der Ansprüche 1 bis 5, die unter Berücksichtigung der logischen Verknüpfung der Funktionsblöcke (21-29, 51-65, 67) der graphischen Darstellung durch die Signalflusspfeile (30, 66) neben den Funktionsblöcken (21-29, 51-65, 67) eines bestimmten Blocktyps einen Funktionsblock eines Blocktyps mit der nächst niedrigeren Hierarchiestufe innerhalb der umsortierten graphischen Darstellung (31, 68) anordnet.

7. Graphische Umgebung nach einem der Ansprüche 1 bis 6, die zunächst das Netzwerk in Unternetzwerke unterteilt, die jeweils nicht durch einen Signalflusspfeil (30, 66) miteinander verbunden sind, und die Umsortierung der Anordnung der Funktionsblöcke (21-29, 51-65, 67) für jedes einzelne Unternetzwerk separat durchführt.

8. Simulationsumgebung eines mathematischen Simulationsprogramms für die graphische Darstellung (20, 40, 50) einer zu simulierenden Funktion, wobei die graphische Simulationsumgebung entsprechend der graphischen Umgebung nach einem der Ansprüche 1 bis 7 ausgeführt ist.

9. Verfahren zum Erzeugen einer graphischen Darstellung, aufweisend folgende Verfahrensschritte:
- Erzeugen einer ersten graphischen Darstellung (20, 40, 50), die mehrere Funktionsblöcke (21-29, 51-65, 67) mehrerer Blocktypen und die Funktionsblöcke (21-29, 51-65, 67) verbindende Signalflusspfeilen (30, 66) aufweist, und
- Zuordnen eines Netzwerks zu der ersten graphischen Darstellung (20, 31, 50), wobei das Zuordnen aufgrund der logischen Verknüpfung der einzelnen Funktionsblöcke (21-29, 51-65, 67) durch die Signalflusspfeile (30, 66) erfolgt.

10. Verfahren nach Anspruch 9, aufweisend, nach dem Zuordnen des Netzwerkes aufgrund der logischen Verknüpfung der einzelnen Funktionsblöcke (21-29, 51-65, 67) durch die Signalflusspfeile (30, 66), folgenden Verfahrensschritt:
- Erzeugen einer zweiten graphischen Darstellung (31, 68) aus der ersten graphischen Darstellung (20, 40, 50) durch Umsortieren der Funktionsblöcke (21-29, 51-65, 67) innerhalb des Netzwerks.

11. Verfahren nach Anspruch 10, bei dem die zweite graphischen Darstellung (31, 68) aus der ersten graphischen Darstellung (20, 40, 50) durch Umsortieren der Funktionsblöcke (21-29, 51-65, 67) innerhalb des Netzwerks aufgrund einer vorher festgelegten hierarchischen Beziehung der Blocktypen zueinander und/oder einer vorher festgelegten Vorzugssignalflussrichtung innerhalb des Netzwerks erzeugt wird.

12. Verfahren nach Anspruch 11, bei dem die Vorzugssignalflussrichtung horizontal und/oder vertikal bezüglich der zweiten graphischen Darstellung (31, 68) verläuft.

13. Verfahren nach Anspruch 11 oder 12, bei dem aufgrund der hierarchischen Beziehung der Blocktypen zueinander zunächst alle Funktionsblöcke (21-29, 51-65, 67) des Blocktyps mit der höchsten Hierarchiestufe der ersten graphischen Darstellung (20, 40, 50) an einer vorher festgelegten Position innerhalb der umsortierten graphischen Darstellung oder einer vorher festgelegten Seite der zweiten graphischen Darstellung (31, 68) angeordnet werden.

14. Verfahren nach einem der Ansprüche 10 bis 13, bei dem unter Berücksichtigung der logischen Verknüpfung der Funktionsblöcke (21-29, 51-65, 67) der ersten graphischen Darstellung (20, 40, 50) durch die Signalflusspfeile (30, 66) neben den Funktionsblöcken eines bestimmten Blocktyps einen Funktionsblock (21-29, 51-65, 67) eines Blocktyps mit der nächst niedrigeren Hierarchiestufe innerhalb der zweiten graphischen Darstellung (31, 68) angeordnet wird.

15. Verfahren nach einem der Ansprüche 10 bis 14, bei dem zunächst das Netzwerk in Unternetzwerke unterteilt wird, die jeweils nicht durch einen Signalflusspfeil (30, 66) miteinander verbunden sind, und die Umsortierung der Anordnung der Funktionsblöcke für jedes einzelne Unternetzwerk separat durchgeführt wird.

16. Verfahren nach einem der Ansprüche 10 bis 15, bei dem die erste graphische Darstellung eine graphische Darstellung (20, 40, 50) einer zu simulierenden Funktion innerhalb einer graphischen Simulationsumgebung eines mathematischen Simulationsprogramms ist.
